# EUROPEAN PATENT APPLICATION

(11) **EP 4 353 860 A1**
(43) Date of publication of application: **17.04.2024**
(21) Application number: 22819347.0
(22) Date of filing: 24.05.2022
(51) Int. Cl.: C23C 2/02, C23C 2/12, C23C 2/26, C23C 14/02, C23C 14/16, C23C 14/24, C23C 14/58, C23C 26/00, C25D 3/56, C25D 5/36, C25D 5/48, C22C 21/02

(54) **PRE-COATED STEEL PLATE FOR HOT FORMING AND PREPARATION METHOD THEREFOR, AND HOT-FORMED STEEL MEMBER AND APPLICATION THEREOF**

(30) Priority: 07.06.2021 CN 202110630714
(71) Applicant: Maanshan Iron & Steel Co., Ltd., Maanshan, Anhui 243000 (CN)
(72) Inventor: ZHOU, Shilong, Maanshan, Anhui 243000 (CN); CUI, Lei, Maanshan, Anhui 243000 (CN); LI, Zitao, Maanshan, Anhui 243000 (CN); JIN, Jiachun, Maanshan, Anhui 243000 (CN); WANG, Lei, Maanshan, Anhui 243000 (CN); DENG, Zongji, Maanshan, Anhui 243000 (CN); LIU, Yonggang, Maanshan, Anhui 243000 (CN); ZHAN, Hua, Maanshan, Anhui 243000 (CN); CHEN, Zhipeng, Maanshan, Anhui 243000 (CN)
(74) Representative: De Clercq & Partners
(86) International application number: PCT/CN2022/094607
(87) International publication number: WO 2022/257749

(57) **Abstract**

Disclosed in the present invention are a pre-coated steel plate for hot forming and a preparation method therefor, and a hot-formed steel member and an application thereof. In the pre-coated steel plate and the preparation method therefor, when the thickness of a pre-coating is 5-19 µm, the corresponding surface roughness of the pre-coating is set, a hot-formed coated steel member can be obtained after hot forming, and the coating on the hot-formed coated steel member has a high surface roughness of Ra≥1.80 µm; the obtained steel member has the advantages of light weight, high surface roughness and good paint adhesion and paint corrosion resistance, and a steel part made of the steel member of the present invention can be applied to a vehicle so as to lighten the weight of the vehicle.

## Description

### FIELD

The present invention relates to a pre-coated steel plate for hot forming and preparation method thereof, and hot-formed steel member and use thereof.

### BACKGROUND

In recent years, as the automotive industry's requirements for safety, energy saving and emissions have become increasingly strict, lightweight of vehicle and safety improvement have become the focus of the automotive industry. Generally, high-strength steel can be configured to realize lightweight and safety improvement. However, by using a traditional cold stamping method, the high-strength steel has problems such as high rebound and difficulty in forming. In this case, hot stamping technology came into being. This technology separates forming and strengthening into two steps to produce ultra-high-strength automotive parts, which has advantages of ultra-high strength, easy forming, and high forming accuracy.

During the hot stamping process, in a case that bare hot-formed steel is used, oxidation and decarburization can inevitably occur on the surface of the steel plate, which affects the strength of the steel plate. In addition, the hot-formed parts need to be shot peened or pickled, which affects the size accuracy of the product. In response to the above problems, coated hot-formed steel has become a mainstream product in the current market. Currently, the hot-formed steel-coated products developed at home and abroad mainly include aluminum-silicon-based (Al-Si) products, zinc-based (such as GI, GA) products, and the like. Zinc-based coating is prone to liquid zinc embrittlement during high-temperature stamping, which leads to stamping cracks. The coating product that has been maturely applied at present is mainly Al-Si. This product was first proposed by Arcelor Mittal and successfully applied to industrial trial production, and has a typical coating composition of 87%Al-10%Si-3%Fe (mass percentage).

Generally, in order to ensure certain formability of a metal sheet, the surface of the material needs to have a certain surface roughness. The principle is that a reasonable microstructure on the surface of the material can better store lubricating oil, thereby improving the formability of the material. Surface roughness refers to the small spacing and tiny unevenness between peak and valley of the processed surface. Generally, the average surface roughness Ra is commonly configured to characterize the surface roughness profile. The higher the surface roughness, the greater the Ra value.

Al-Si coated products have good coating properties such as phosphating and electrophoresis before heating. However, in a case that Al-Si coated products are used in the hot stamping process, due to mutual diffusion between the coating and the substrate during the heating process, Fe-Al and Fe-Al-Si alloy coatings are formed, which changes the properties of the coating, and the phosphating performance of the coating is poor at this time. In order to ensure the paint adhesion and subsequent corrosion resistance of such as electrophoresis, the surface roughness Ra of the coating after hot forming needs to be at a high value. Studies have shown that only when the Al-Si-coated hot-formed steel has a large surface roughness of the coating after hot forming, good paint adhesion and corrosion resistance can be ensured.

Patent CN101583486B of Arcelor Mittal (hereinafter referred to as Patent 1) provides a coated steel strip and a hot stamping product prepared therefrom. The pre-coating of the coated steel strip according to Patent 1 has a typical composition of 8%-11% Si, 2%-4% Fe, and balance of aluminum and inherent impurities, and a thickness of 20 µm to 33 µm, wherein 25 µm is generally used in industry. In addition, the process window of hot forming and coating structure after hot forming are described in detail. The patent proposes that in a case that a certain thickness (not less than 20 µm) of the pre-coating is ensured, the surface roughness of the coating of an Al-Si product after hot forming is high. However, in a case that the thickness of the pre-coating is small, less than 20 µm, the amount of liquefaction of the coating after heating is small. In this case, the liquefied coating mainly manifests as filling pits, and large surface roughness Ra cannot be guaranteed after heating, resulting in reduced adhesion of subsequent paints to the surface and reduced corrosion resistance.

Patent CN108588612B (hereinafter referred to as Patent 2) provides a hot stamping member, a pre-coated steel plate for hot stamping and a hot stamping process. The pre-coated steel plate provided by Patent 2 is pre-coated with an aluminum or aluminum alloy coating at a thickness of 3 µm to 19 µm. The hot forming process and the coating structure after hot forming are also limited. Patent 2 proposes that the surface roughness of the alloyed layer is not determined by the thickness and structure of the alloyed layer. As long as the pre-coating is liquefied during the heating process, it will lead to great surface roughness. However, the inventor of the present invention found that when the thickness of the pre-coating is small, such as the thickness range of the pre-coating in Patent 2, even if the coating is liquefied, the liquefied coating mainly manifests as filling pits because the amount of liquefaction of the coating after heating is small, and large surface roughness Ra cannot be guaranteed after heating. In addition, Patent 2 proposes that the corrosion resistance performance of the coating after hot stamping is only related to a layer a (interdiffusion layer). However, research has found that even if the formation of the layer a is controlled, good paint adhesion and corrosion resistance cannot be guaranteed, which is related to that high surface roughness of the coating cannot be guaranteed after heating.

The small coating thickness of aluminum or aluminum alloy pre-coating meets the current requirements for lightweight of automobiles and is more economical and environmentally friendly. However, in a case that the thickness of the pre-coating is small, how to ensure a high surface roughness of the coating after heating is crucial to improving paint adhesion and corrosion resistance of aluminum or aluminum alloy pre-coating after hot forming.

### SUMMARY

### 1. Problems to be solved

The present invention is based on the fact that existing pre-coated aluminum or aluminum alloy coated steel plates cannot guarantee high surface roughness of the coating after heating when the thickness of the pre-coating is small. The purpose of the present invention is to provide a pre-coated steel plate for hot forming, a preparation method and process for controlling the pre-coated steel plate, so that the coated steel member obtained from hot forming of the pre-coated steel plate has a high surface roughness of Ra ≥ 1.80 µm. Moreover, the obtained steel member has light weight, high surface roughness, good paint adhesion and paint corrosion resistance. Steel parts made of the steel member of the present invention can be configured in vehicles to realize lightweight of automobiles.

### 2. Technical solutions

In order to solve the above problems, the present invention adopts the following technical solutions.

The inventor found through research that in order to ensure good paint adhesion and corrosion resistance of the pre-coating (aluminum or aluminum alloy coating) after hot forming, the surface roughness of the coating after hot forming needs to be large. The thickness of the pre-coating of the present invention is greater than or equal to 5 µm and less than or equal to 19 µm. In a case that the thickness of the pre-coating is small, in order to ensure great surface roughness requirement, the surface roughness of the coating after hot forming can be improved by increasing the surface roughness of the pre-coating. The thickness of the pre-coating in the present invention is greater than or equal to 5 µm. Since if the thickness of the pre-coating is too thin (less than 5 µm), the thickness of the coating is difficult to be controlled during actual production, and the surface quality of the coating is poor.

In order to ensure that the coating has Ra ≥ 1.80 after hot forming, it is necessary to ensure a large surface roughness of the pre-coating. For example, in a case that the thicknesses of the pre-coating is 5 µm, 10 µm, 15 µm, and 19 µm respectively, Ra of the pre-coating is greater than or equal to 1.85, 2.00, 2.40, and 2.80 respectively. In addition, in a case that the surface roughness Ra of the pre-coating is too large, such as greater than 3.50, the surface roughness of the coating after hot forming is also too large, and the surface microstructure is too coarse, which can lead to poor paint effect after painting. The pre-coating according to the present invention has a surface roughness Ra ≤ 3.50.

Specifically, the present invention provides a pre-coated steel plate, wherein a pre-coating is provided on at least one surface of a base steel, and the pre-coating has a thickness of 5 µm to 19 µm, wherein in a case that the pre-coating has a thickness of greater than or equal to 5 µm and less than or equal to 10 µm, the thickness of the pre-coating and the surface roughness of the pre-coating are limited within pattern ABCD, which comprises coordinates of the thickness of the pre-coating and the surface roughness of the pre-coating defined by A (5 µm, 3.5 µm), B (10 µm, 3.5 µm), C (10 µm, 2.0 µm), and D (5 µm, 1.85 µm); in a case that the thickness of the pre-coating is greater than 10 µm and less than or equal to 15 µm, the thickness of the pre-coating and surface roughness of the pre-coating are defined within pattern BEFC, which comprises coordinates of the thickness of the pre-coating and the surface roughness of the pre-coating defined by B (10 µm, 3.5 µm), E (15 µm, 3.5 µm), F (15 µm, 2.4 µm), and C (10 µm, 2.0 µm); in a case that the thickness of the pre-coating is greater than 15 µm and less than or equal to 19 µm, the thickness of the pre-coating and surface roughness of the pre-coating are defined within pattern EGHF, which comprises coordinates of the thickness of the pre-coating and the surface roughness of the pre-coating defined by E (15 µm, 3.5 µm), G (19 µm, 3.5 µm), H (19 µm, 2.8 µm), and F (15 µm, 2.4 µm).

Wherein, the surface roughness of the pre-coating is formed by the imprinting of the surface microgeometry of the work roll of the production line rolling mill. In general, the surface roughness of the pre-coating can be adjusted by adjusting the rolling process parameters such as the surface roughness of the roll, rolling force, and roll surface properties. It is worth mentioning that after the hot-dip plating process, at least one surface of the substrate has a pre-coating structure (aluminum or aluminum alloy coating). The pre-coating structure comprises, from the substrate side to the surface, an intermetallic compound layer (Fe₂Al₅, Fe₂SiAl₇), and an aluminum or aluminum alloy coating (unalloyed). The hardness of the intermetallic compound layer is significantly higher than that of the aluminum coating. In a case that the thickness of the pre-coating of the present invention is small, less than or equal to 19 µm, as the thickness of the pre-coating decreases, the thickness of the aluminum coating becomes smaller, and the surface roughness of the pre-coating becomes smaller under the same conditions. High surface roughness can be achieved by increasing the surface roughness of the roll, increasing the rolling force, and the like. Therefore, a method for preparing the above-mentioned pre-coated steel plate is provided, comprising steelmaking→continuous casting→hot rolling→pickling and cold rolling→coating process. The coating process comprises a skin passing process. In the skin passing process, the surface roughness Ra of a roll is 3.0 µm to 6.0 µm, and a rolling force is 4000 kN to 9000 kN.

Furthermore, in the coating process, a pre-coating is coated by a method of hot-dip plating, vacuum evaporation or electroplating or other coating methods, as long as the method can achieve the adhesion of the coating.

Furthermore, in the coating process, a coating liquid comprises, in mass percentage, 8-11% of Si, 2-4% of Fe, and balance of aluminum or aluminum alloy and inevitable impurities.

Furthermore, the coating process comprises a continuous annealing process, which has parameters as follows: the annealing is conducted at a temperature controlled at 720°C to 850°C, and kept at this temperature for 60 s to 120 s under a reducing atmosphere comprising 5-10% H₂+ N₂ by volume percentage (that is, in terms of volume percentage of the reducing atmosphere, H₂ accounts for 5-10%, and the rest is N₂), the oxygen content is controlled below 20 ppm, and the dew point is controlled at -60°C to 0°C.

A coated hot-formed steel member is provided, which is prepared from the above-mentioned pre-coated steel plate through a hot forming process, wherein the surface roughness of the steel member meets Ra ≥ 1.80 µm.

Furthermore, the coated hot-formed steel member is produced from the steel plate pre-coated with aluminum or aluminum alloy coating by heating, hot stamping or other heat treatment operations, and the heating can be conducted by a method of resistance heating, radiant heating or induction heating, which is not limited to the above method.

Furthermore, the coating structure after hot forming consists of, from the base steel to the surface, only a first layer; wherein the first layer is located on the side of the base steel, that is, the outermost side, and the first layer is an interdiffusion layer containing Al and Si (α-Fe and Fe₃Al), which comprises greater than or equal to 80% of Fe by weight, less than or equal to 5% of Si by weight, and balance of Al.

Furthermore, the coating structure after hot forming consists of, from the base steel to the surface, a first layer and a second layer sequentially:
the first layer is located on the side of the base steel, that is, the innermost side, and the first layer is an interdiffusion layer containing Al and Si, which comprises greater than or equal to 80% of Fe by weight, less than or equal to 5% of Si by weight, and balance of Al,
the second layer is located outside the first layer, and is a first intermetallic compound layer containing Al and Si, which comprises 55% to 79% of Fe by weight, greater than or equal to 2% of Si by weight, and balance of Al.

Furthermore, the coating structure after hot forming consists of, from the base steel to the surface, a first layer, a second layer and a discontinuous surface layer sequentially:
the first layer is located on the side of the base steel, that is, the innermost side, and the first layer is an interdiffusion layer containing Al and Si, which comprises greater than or equal to 80% of Fe by weight, less than or equal to 5% of Si by weight, and balance of Al,
the second layer is located outside the first layer, and is a first intermetallic compound layer containing Al and Si, which comprises 55% to 79% of Fe by weight, greater than or equal to 2% of Si by weight, and balance of Al,
the surface layer is located outside the second layer, discontinuous, and comprises a first intermetallic compound containing Al and Si and a second intermetallic compound containing Al and Si, wherein the first intermetallic compound layer comprises 55% to 79% of Fe by weight, greater than or equal to 2% of Si by weight, and balance of Al, and the second intermetallic compound comprises 30% to 50% of Fe by weight, less than or equal to 2% of Si by weight, and balance of Al.

Furthermore, the coating structure after hot forming consists of, from the base steel to the surface, a first layer, a second layer and a third layer sequentially:
the first layer is located on the side of the base steel, that is, the innermost side, and the first layer is an interdiffusion layer containing Al and Si, which comprises greater than or equal to 80% of Fe by weight, less than or equal to 5% of Si by weight, and balance of Al,
the second layer is located outside the first layer, and is a second intermetallic compound layer containing Al and Si, which comprises 30% to 50% of Fe by weight, less than or equal to 2% of Si by weight, and balance of Al,
the third layer is located outside the second layer, and is a first intermetallic compound layer containing Al and Si, which comprises 55% to 79% of Fe by weight, greater than or equal to 2% of Si by weight, and balance of Al.

Furthermore, the coating structure after hot forming consists of, from the base steel to the surface, a first layer, a second layer, a third layer and a discontinuous surface layer sequentially:
the first layer is located on the side of the base steel, that is, the innermost side, and the first layer is an interdiffusion layer containing Al and Si, which comprises greater than or equal to 80% of Fe by weight, less than or equal to 5% of Si by weight, and balance of Al,
the second layer is located outside the first layer, and is a second intermetallic compound layer containing Al and Si, which comprises 30% to 50% of Fe by weight, less than or equal to 2% of Si by weight, and balance of Al,
the third layer is located outside the second layer, and is a first intermetallic compound layer containing Al and Si, which comprises 55% to 79% of Fe by weight, greater than or equal to 2% of Si by weight, and balance of Al,
the surface layer is located outside the third layer, discontinuous, and comprises a first intermetallic compound containing Al and Si and a second intermetallic compound containing Al and Si, wherein the first intermetallic compound layer comprises 55% to 79% of Fe by weight, greater than or equal to 2% of Si by weight, and balance of Al, and the second intermetallic compound comprises 30% to 50% of Fe by weight, less than or equal to 2% of Si by weight, and balance of Al.

Furthermore, the coating structure after hot forming consists of, from the base steel to the surface, a first layer, a second layer, a third layer and a fourth layer sequentially:
the first layer is located on the side of the base steel, that is, the innermost side, and the first layer is an interdiffusion layer containing Al and Si, which comprises greater than or equal to 80% of Fe by weight, less than or equal to 5% of Si by weight, and balance of Al,
the second layer is located outside the first layer, and is a second intermetallic compound layer containing Al and Si, which comprises 30% to 50% of Fe by weight, less than or equal to 2% of Si by weight, and balance of Al,
the third layer is located outside the second layer, and is a first intermetallic compound layer containing Al and Si, which comprises 55% to 79% of Fe by weight, greater than or equal to 2% of Si by weight, and balance of Al,
the fourth layer is located outside the third layer, and is a second intermetallic compound layer containing Al and Si, which comprises 30% to 50% of Fe by weight, less than or equal to 2% of Si by weight, and balance of Al.

Furthermore, the coated hot-formed steel member has a total thickness of 0.4 mm to 3.0 mm.

Furthermore, the chemical composition of the base steel is not limited, including low carbon steel, medium carbon steel, high carbon steel, and the like. However, it should be noted that too high content of carbon or alloy elements in the base steel causes problems such as difficulty in welding during production and poor coating quality.

A steel product is provided, comprising the above-mentioned coated hot-formed steel member.

Aland motor vehicle is provided, comprising the above-mentioned coated hot-formed steel member.

### 3. Beneficial effects

Compared with existing pre-coated aluminum or aluminum alloy coated steel plates, wherein when the pre-coating has small thickness, high surface roughness of the coating after hot forming cannot be guaranteed, the present invention provides a pre-coated steel plate and a preparation method thereof. A coated hot-formed steel member can be prepared from the pre-coated steel plate prepared by controlling by the method after hot forming. The coating on the coated hot-formed steel member has a high surface roughness Ra ≥ 1.80 µm, and the obtained steel member has light weight, high surface roughness, good paint adhesion and paint corrosion resistance. The steel parts prepared using the steel member of the present invention are applied to vehicles to realize lightweight of vehicles.

After painstaking research, the inventor found that the change in surface roughness of the aluminum or aluminum alloy coating after heating mainly occurs during the liquefaction and solidification process of the coating. The surface roughening of the coating after heating is mainly divided into two processes: one is that liquefaction coating fills the pits (tiny spacing, "valley"); the other is that the liquefied coating is roughened. In a case that the thickness of the pre-coating is large, such as not less than 20 µm, the amount of liquefaction of the coating after heating is large. In this case, the liquefied coating continues to roughen after filling the pits, and the surface roughness Ra is large. In a case that the thickness of the pre-coating is small, the amount of liquefaction of the coating after heating is small. In this case, the liquefied coating mainly manifests as filling pits, and large surface roughness Ra cannot be guaranteed after heating.

Therefore, the surface roughness Ra of the Al-Si coating after heating is not only related to the thickness of the pre-coating, but also related to the surface roughness Ra of the pre-coating. In a case that the thickness of the pre-coating is large, such as not less than 20 µm, the surface roughness Ra of the pre-coating has a relatively small impact on the surface roughness Ra of the coating after heating. In a case that the surface roughness Ra of the pre-coating is within a normal range between 1.00 and 2.00, the liquefied coating fills the pits and continues to roughen, in which case, the surface roughness Ra is large. In a case that the thickness of the pre-coating is small, the surface roughness Ra of the pre-coating has a great impact on the surface roughness Ra of the coating after heating. The liquefied coating mainly manifests as filling pits. In this case, the surface roughness Ra of the pre-coating can be increased, so that the liquefied coating incompletely fills pits or the surface roughness Ra of the pre-coating can be minimized so that the liquefied coating can continue to roughen after filling pits to improve the surface roughness Ra of the coating after heating. Generally, there are two ways to ensure a large surface roughness Ra of the Al-Si coating after heating: one is to increase the thickness of the pre-coating, such as not less than 20 µm; the other is to increase the surface roughness Ra of the pre-coating or reduce the surface roughness Ra of the pre-coating in a case that the thickness of the pre-coating is small. However, studies have found that in a case that the surface roughness Ra of the pre-coating is small, less than 1.00, and the thickness of the pre-coating is less than 20 µm, the surface roughness Ra after heating cannot be guaranteed to be ≥ 1.80. The results are shown in Table 1.

**Table 1 Surface roughness of pre-coatings with different thicknesses before and after heating (low surface roughness of pre-coating)**

| Thicknesses of pre-coating (µm) | 7 | 10 | 15 | 17 | 20 |
|---|---|---|---|---|---|
| Surface roughness Ra before heating (µm) | 0.94 | 0.99 | 0.44 | 0.69 | 0.99 |
| Surface roughness Ra after heating (µm) | 0.88 | 1.08 | 1.33 | 1.48 | 1.86 |

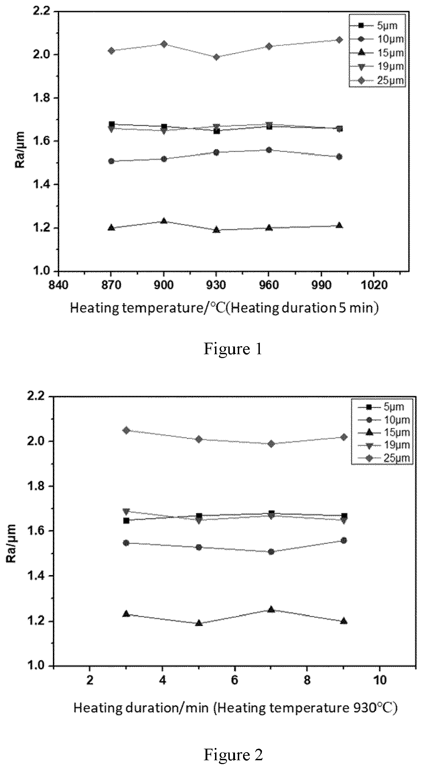

In addition, the inventor found that the specific heating process has little effect on the surface roughness Ra of the coating after heating. The effects of common heating temperature and heating duration on the roughness of the pre-coating with a thickness of 5 µm, 10 µm, 15 µm, 19 µm, and 25 µm after heating are shown in Figure 1 and Figure 2, wherein, the pre-coating with a thickness of 5 µm has an average roughness Ra of 1.69, the pre-coating with a thickness of 10 µm has an average roughness Ra of 1.67, the pre-coating with a thickness of 15 µm has an average roughness Ra of 1.69, the pre-coating with a thickness of 19 µm has an average roughness Ra of 1.72, and the pre-coating with a thickness of 25 µm has an average roughness Ra of 1.70.

The inventor found through research that in a case that the thickness of the pre-coating is greater than or equal to 5 µm and less than or equal to 19 µm, as the heating temperature increases or the heating duration prolongs, that is, as the degree of alloying of the coating increases, the coating structure changes with regularity:
(1) In a case that the heating temperature is too low or the heating duration is too short, the coating is not completely alloyed, and aluminum or Fe₂SiAl₇ is generally present on the surface.
(2) In a case that the coating begins to be fully alloyed, the coating structure has a four-layer structure from the base steel to the surface, which are an interdiffusion layer (α-Fe and Fe₃Al), a second intermetallic compound layer (Fe-Al intermetallic compound layer), a first intermetallic compound layer (Fe-Al-Si intermetallic compound layer), and a second intermetallic compound layer (or surface layer, Fe-Al intermetallic compound);
   wherein, the interdiffusion layer comprises α-Fe and Fe₃Al containing Al and Si, wherein the content of Fe is greater than or equal to 80% by weight, the content of Si is less than or equal to 5% by weight, and the rest is Al;
   in the second intermetallic compound layer (i.e., the Fe-Al intermetallic compound layer and the surface layer), the content of Fe is 30% to 50% by weight, the content of Si is less than or equal to 2% by weight, and the rest is Al;
   in the first intermetallic compound layer (Fe-Al-Si intermetallic compound layer), the content of Fe is 55% to 79% by weight, the content of Si is greater than or equal to 2% by weight, and the rest is Al.
(3) In a case that the degree of alloying is further improved, the interdiffusion layer and the first intermetallic compound layer (Fe-Al-Si intermetallic compound layer) gradually become thicker. In a case that part of the first intermetallic compound layer extends to the surface, the surface layer of the coating is discontinuous, and the structure of the coating is a three-layer structure and a discontinuous surface layer from the base steel to the surface, that is, a diffusion layer (α-Fe and Fe₃Al), a second intermetallic compound layer, a first intermetallic compound layer and a discontinuous surface layer. In this case, the discontinuous surface layer is a mixed structure containing the first intermetallic compound and the second intermetallic compound. In a case that the first intermetallic compound layer completely occupies the surface, the coating structure is a three-layer structure from the base steel to the surface, that is, a diffusion layer (α-Fe and Fe₃Al), a second intermetallic compound layer, and a first intermetallic compound layer.
(4) In a case that the interdiffusion layer and the first intermetallic compound layer (Fe-Al-Si intermetallic compound layer) are further thickened, the second intermetallic compound layer between the interdiffusion layer and the first intermetallic compound layer is completely transformed into an interdiffusion layer or Fe-Al-Si intermetallic compound layer. In this case, the coating structure is a two-layer structure or plus a discontinuous surface layer from the base steel to the surface, that is, an interdiffusion layer and a first intermetallic compound layer or plus a discontinuous surface layer. In a case that there is a discontinuous surface layer, the discontinuous surface layer is a mixed structure containing a first intermetallic compound and a second intermetallic compound.
(5) In a case that the coating continues to be alloyed, the content of Fe in the coating further increases, and the first intermetallic compound layer (Fe-Al-Si intermetallic compound layer) gradually transforms into Fe₃Al. In this case, the coating only consists of an interdiffusion layer.

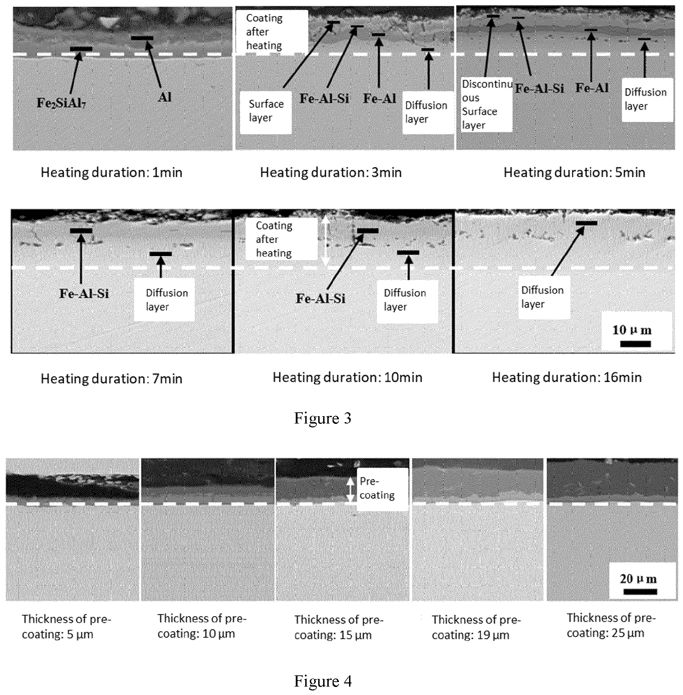

In addition, the inventor found through research that the coating structure after heating has little impact on the surface roughness Ra of the coating. In the study, the thickness of the pre-coating is selected as 10 µm, the total thickness of the steel plate is selected as 1.4 mm, the measured average roughness Ra of the pre-coating is 1.67, the heating temperature is 930°C, and the heating duration is selected as 1 min, 3 min, 5 min, 7 min, 10 min, and 16 min. The roughness after heating was measured and the coating structure and coating composition after heating were analyzed. The roughness after heating is shown in Table 2. The composition of each layer of the coating after heating is shown in Table 3. The coating structure is shown in Figure 3.

From the perspective of the coating structure after heating, in a case that the heating duration is 1 min, the coating is not completely alloyed, and there is still an unalloyed aluminum coating on the surface. In a case that the heating duration is 3 min, the coating is fully alloyed, and the coating structure is a four-layer structure from the base steel to the surface, including an interdiffusion layer (α-Fe and Fe₃Al), a second intermetallic compound layer (Fe-Al intermetallic compound layer), a first intermetallic compound layer (Fe-Al-Si intermetallic compound layer) and a surface layer (Fe-Al intermetallic compound). In a case that the heating duration is 5 minutes, the coating transforms into three layers and a discontinuous surface layer. The coating structure comprises, from the base steel to the surface, an interdiffusion layer (α-Fe and Fe₃Al), a second intermetallic compound layer (Fe-Al intermetallic compound layer), a first intermetallic compound layer (Fe-Al-Si intermetallic compound layer) and a discontinuous surface layer. In a case that the heating duration is 7 minutes, the coating structure transforms into two layers, which comprises, from the base steel to the surface, an interdiffusion layer (α-Fe and Fe₃Al) and a first intermetallic compound layer (Fe-Al-Si intermetallic compound layer). In a case that the heating duration is 10 minutes, the coating still comprises two layers. The coating structure comprises, from the base steel to the surface, an interdiffusion layer (α-Fe and Fe₃Al) and a first intermetallic compound layer (Fe-Al-Si intermetallic compound layer). In a case that the heating duration is 16 minutes, the coating transforms into one layer, and the coating only consists of an interdiffusion layer (α-Fe and Fe₃Al).

From the perspective of the surface roughness Ra of the coating after heating, in a case that the heating duration is 1 minute, the surface roughness Ra of the coating after heating is 1.62, which is slightly lower than the surface roughness Ra of 1.67 before heating. This is because there is still unalloyed aluminum coating in the coating, which leads to small amount of liquefaction of coating and pits filling. In a case that the heating duration is greater than or equal to 3 minutes, the coating is completely alloyed. In this case, as the heating duration increases, the coating structure transforms from four layers to three layers or plus a discontinuous surface layer, two layers or one layer. In this case, the surface roughness Ra of the coating after heating changes little. Generally, the coating structure after heating has small impact on the surface roughness Ra of the coating after heating.

**Table 2 Surface roughness Ra of coating under different heating durations**

| Heating duration (min) | 1 | 3 | 5 | 7 | 10 | 16 |
|---|---|---|---|---|---|---|
| Surface roughness Ra after heating (µm) | 1.62 | 1.53 | 1.52 | 1.54 | 1.52 | 1.55 |

**Table 3 Composition of each layer of the coating under different heating durations**

| Heating duration /min | Analysis layer | Element (weight %) | | | Phase |
|---|---|---|---|---|---|
| | | Fe | Al | Si | |
| 1 | Base side | 32.9 | 56.6 | 10.5 | Fe₂SiAl₇ |
| | Surface layer | 5.6 | 92.6 | 1.8 | Al |
| 3 | Interdiffusion layer | 95.8 | 3.2 | 1.0 | α-Fe+Fe₃Al |
| | Fe-Al layer | 47.0 | 51.4 | 1.6 | Fe₂Al₅ |
| | Fe-Al-Si layer | 63.6 | 26.7 | 9.7 | Fe₃SiAl₃ |
| | Continuous surface layer | 46.9 | 51.6 | 1.5 | Fe₂Al₅ |
| 5 | Interdiffusion layer | 84.0 | 12.4 | 3.6 | Fe₃Al |
| | Fe-Al layer | 48.2 | 50.5 | 1.3 | Fe₂Al₅ |
| | Fe-Al-Si layer | 64.8 | 30.0 | 5.2 | Fe₆SiAl₆ |
| | Discontinuous surface layer | 47.6 | 51.5 | 0.9 | Fe₂Al₅ |
| 7 | Interdiffusion layer | 92.0 | 6.3 | 1.7 | α-Fe+Fe₃Al |
| | Fe-Al-Si layer | 66.1 | 30.5 | 3.4 | Fe₁₀SiAl₉ |
| 10 | Interdiffusion layer | 93.3 | 5.5 | 1.2 | α-Fe+Fe₃Al |
| | Fe-Al-Si layer | 68.4 | 29.3 | 2.3 | Fe₁₅SiAl₁₃ |
| 16 | Interdiffusion layer | 85.0 | 12.4 | 2.6 | Fe₃Al |

Generally, for aluminum or aluminum alloy coating, the heating process or the coating structure after heating has little impact on the surface roughness Ra of the coating after heating. The surface roughness Ra of the coating after heating is mainly related to the thickness of the pre-coating and the surface roughness of the pre-coating. In a case that the thickness of the pre-coating is large, the surface roughness Ra of the pre-coating has a relatively small impact on the surface roughness Ra of the coating after heating. The surface roughness Ra of the coating after heating is large. However, in a case that the surface roughness Ra of the pre-coating is small, the surface roughness Ra of the pre-coating has a great impact on the surface roughness Ra of the coating after heating. In a case that the surface roughness Ra of the pre-coating is large, the surface roughness Ra of the coating after heating can be guaranteed to be ≥ 1.80, thus ensuring good paint adhesion and corrosion resistance.

### BRIEF DESCRIPTION OF THE DRAWINGS

Figure 1 shows the relationship of the surface roughness Ra of the coating after heating changing along the heating temperature with a thickness of the pre-coating of 5 µm, 10 µm, 15 µm, 19 µm, and 25 µm.
Figure 2 shows the relationship of the surface roughness Ra of the coating after heating changing along the heating duration with a thickness of the pre-coating of 5 µm, 10 µm, 15 µm, 19 µm, and 25 µm.
Figure 3 shows the relationship of the coating structure after heating at 930°C changing along the heating duration with a thickness of the pre-coating of 10 µm and a total thickness of the steel plate of 1.4 mm.
Figure 4 shows the coating structure before heating with a thicknesses of the pre-coating of 5 µm, 10 µm, 15 µm, 19 µm, and 25 µm.
Figure 5 shows the typical surface morphology of the pre-coating.
Figure 6 shows the surface morphology of the coating after heating with a thickness of the pre-coating of 5 µm, 10 µm, 15 µm, 19 µm, and 25 µm.
Figure 7 shows the limited range of the thickness of the pre-coating and the surface roughness of the pre-coating of the present invention, wherein the pre-coating has a thickness of greater than or equal to 5 µm and less than or equal to 19 µm.

### DETAILED DESCRIPTION OF EMBODIMENTS

The present invention can be further described below with reference to specific examples and drawings. The following examples or experimental data are intended to illustrate the present invention. It should be clear to those skilled in the art that the present invention is not limited to these examples or experimental data.

First, the steel plate pre-coated with aluminum or aluminum alloy coating of the present invention has a thickness of 0.4 mm to 3.0 mm, wherein the pre-coating is has a thickness of 5 µm to 19 µm. This example provides steel plates with a thickness of 0.8 mm, 1.4 mm, and 2.0 mm respectively. The pre-coatings have a thickness of 5 µm (in the present invention), 10 µm (in the present invention), 15 µm (in the present invention), 19 µm (in the present invention), and 25 µm (comparison), wherein the pre-coating is coated on the upper and lower surfaces of the steel plate.

22MnB5, commonly used in the market, is used as the base steel of the steel plate of the present invention. The pre-coating can be achieved by hot-dip plating. A typical hot-dip plating solution comprises (in mass percentage) 8% to 11% of Si, 2% to 4% of Fe and balance of aluminum or aluminum alloy and inevitable impurities. However, the present invention is not limited to this coating method and plating solution composition. Other coating methods or other aluminum or aluminum alloy compositions can be used. The main function of Si element in the plating solution is to form an Fe-Al-Si inhibition layer on the surface of the steel plate, which can effectively hinder the formation of a brittle phase Fe₂Al₅ and improve the formability of the coating. In a case that the content of Si exceeds 10%, this effect is significantly weakened. Experimental research shows that it is generally appropriate to control the content of Si in aluminum liquid at 8% to 11%. Fe has different solubility at different temperatures of the plating solution. The conventional temperature of an aluminum-silicon plating solution is 640°C to 680°C, in which case, the solubility of Fe in the plating solution is 2% to 4%.

As an example, the base steel and pre-coating of the present invention have compositions shown in Table 4.

**Table 4 Composition of base steel and pre-coating of the present invention**

| Chemical component (weight %) | C | Mn | P | B | Ti | Cr | Al | Si | Fe |
|---|---|---|---|---|---|---|---|---|---|
| Base steel | 0.23 | 1.27 | 0.015 | 0.0025 | 0.035 | 0.15 | 0.038 | 0.25 | Bal. |
| Pre-coating | - | - | - | - | - | - | Bal. | 9.0 | 2.2 |

Wherein, Bal. represents the remainder besides other elements.

The steel plate pre-coated with aluminum or aluminum alloy coating of the present invention can be produced through the following process: steelmaking → continuous casting → hot rolling → pickling and cold rolling → coating process.
(1) Steelmaking comprises pretreating iron liquid, converter smelting, alloy fine-tuning, and refining to obtain pure steel ultimately.
(2) Continuous casting comprises injecting the refined molten steel into a tundish, then distributing the molten steel into each crystallizer by the tundish, casting forming, crystallizing, then pulling out the casting, and cutting into a slab with a certain length.
(3) Hot rolling comprises hot rolling the above slab at 1000°C to 1300°C, wherein the temperature of the slab leaving the heating furnace is controlled above 1 100°C, and the final rolling temperature is controlled above 600°C to obtain a hot-rolled steel plate; coiling the above hot-rolled steel plate, wherein the coiling is conducted at a temperature controlled below 800°C.
(4) Pickling and cold rolling comprises further pickling and cold-rolling the hot-rolled steel plate to obtain a pickled and cold-rolled steel plate.
(5) Coating process comprises substrate cleaning → continuous annealing → hot-dip plating → coating thickness control → cooling after plating → skin passing → straightening → oiling → coiling and unloading.
   (a) Substrate cleaning: In order to ensure good coating quality, the amount of residual oil on one side of the steel plate after cleaning is controlled below 20 mg/m², and the amount of residual iron on one side of the steel plate is controlled below 10 mg/m².
   (b) Continuous annealing: The annealing temperature and atmosphere are crucial to the quality, product structure and performance of the hot-dip plating coating. The annealing is conducted at a temperature controlled at 720°C to 850°C, and kept at this temperature for 60 s to 120 s, a reducing atmosphere of 5% to 10% H₂+N₂ (by volume percentage) is used, the content of oxygen is controlled below 20 ppm, and the dew point is controlled at -60°C to 0°C.
   (c) Hot-dip plating: The dip plating is conducted at a temperature controlled at 640°C to 680°C for 2 s to 8 s.
   (d) Coating thickness control: The thickness of the coating is controlled by blowing nitrogen with an air knife or compressing air. The thickness of the coating of the present invention is controlled at 5 µm to 19 µm on one side.
   (e) Cooling after plating: The cooling after plating is conducted by air cooling. The steel plate is cooled to below 300°C, and then water-cooled to below 100°C.
   (f) Skin passing: According to the requirements on the roughness of the pre-coating, the parameters of the skin passing roll process are adjusted for production. This process also has the effect of improving mechanical performance and flatness of steel strip.
   (g) Straightening: After straightening the steel strip, the flatness of the steel strip is further improved.
   (h) Oiling: The surface of the steel strip is coated with anti-rust oil through an electrostatic oiling machine.
   (i) Coiling and unloading: The steel strip is coiled and tensioned, and finally formed into a coil and unloaded.

The structure of the pre-coating produced using the above process is shown in Figure 4. The thickness of the pre-coatings according to the present invention is, from left to right, 5 µm, 10 µm, 15 µm, 19 µm, and 25 µm (comparison) respectively.

After analysis, the base structure of each steel plate is ferrite and pearlite structure. The pre-coating from the base side to the surface is respectively an intermetallic compound layer (Fe₂Al₅, Fe₂SiAl₇) and an aluminum coating. The thickness of the intermetallic compound layer of each pre-coating is equivalent, about 4.5 µm (the thickness of the Fe₂Al₅ layer is less than 0.5 µm). The difference lies in the thickness of the aluminum coating. The thickness of the aluminum coating of each pre-coating is respectively 0.5 µm, 5.5 µm, 10.5 µm, 14.5 µm, and 20.5 µm.

For the above-mentioned steel plates with a thicknesses of a base plate of 0.8 mm, 1.4 mm, and 2.0 mm, and a thicknesses of the pre-coating of 5 µm, 10 µm, 15 µm, 19 µm, and 25 µm respectively, the parameters of the skin passing roll process are adjusted to produce pre-coated steel plates with different surface roughness Ra values. It is worth mentioning that since the surface hardness of the aluminum or aluminum alloy pre-coating is soft and the Vickers hardness is less than 100, in a case that the aluminum or aluminum alloy pre-coated steel plate is finished, the roughness of the skin passing roll can be partially transferred to the aluminum or aluminum alloy pre-coated steel plate. Generally, the transfer rate (aluminum or aluminum alloy pre-coating roughness/ skin passing roll roughness) does not exceed 80%. As the skin passing rolling force increases, the transfer rate increases. As the skin passing roll wears, the transfer rate gradually decreases. The present invention produces a pre-coated steel plate with a high surface roughness Ra value, which can be achieved by increasing the roughness of the skin passing roll or increasing the skin passing rolling force. In addition, it should be noted that the thickness of the pre-coating in the present invention is small, less than or equal to 19 µm. As the thickness of the pre-coating decreases, the thickness of the aluminum coating decreases, the improvement of the surface roughness becomes more difficult to realize, and the requirements for the skin passing roll roughness and rolling force become higher.

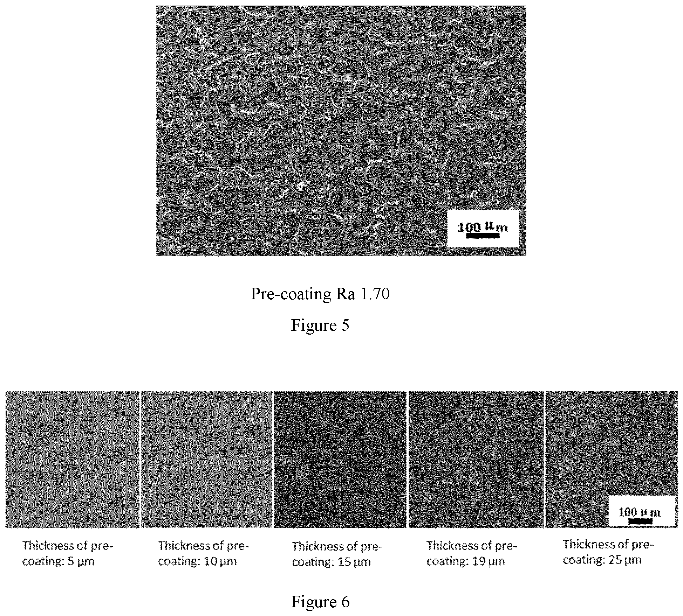

To measure the surface roughness of the pre-coated steel plate, the width direction of the steel plate (i.e. the width direction of the steel strip) is generally selected to be measured 3 times along the edge, middle and edge respectively for a total of 9 times, and finally the average value is taken. GB/T2523-2008 measurement method of surface roughness and peak number of cold-rolled metal sheets (strips) is adopted as measurement standard, wherein the cut-off wavelength is 0.8 mm, the test distance is 4.8 mm. The pre-coatings with different surface roughness Ra values have similar surface morphologies, which all have a certain number of pits on the surface, and the difference is that the greater the surface roughness Ra value of the pre-coating, the greater the depth of the pits. Typical surface morphology of the pre-coating is shown in Figure 5 (Example 24).

An appropriate heating process for the above-mentioned pre-coated steel plate is selected to ensure that the pre-coating is completely alloyed (there is no unalloyed aluminum coating). Generally, the heating temperature is not less than 860°C, and the heating duration is not less than 3 minutes. In a case that the thickness of the steel plate is great or the thickness of the pre-coating is great, the heating temperature or heating duration should be increased appropriately. In the examples of the present invention, a resistance heating furnace is adopted. First, the width direction of the steel plate (that is, the width direction of the steel strip) is selected to process the steel plate along the edge, middle, and edge into a sample plate with a size of 150*300 mm respectively. After putting the sample plate into the heating furnace for a certain period of time, the sample plate is taken out, placed on a flat plate quenching mold, and pressed, and the pressure is kept for a certain period of time. Then the surface roughness of the steel plate after heating is measured according to the same measurement method, and finally the average value is taken.

The surface roughness Ra of the pre-coatings selected is similar (about 1.70) and the thickness of the pre-coatings is 5 µm, 10 µm, 15 µm, 19 µm, and 25 µm respectively. The surface roughness of the coatings before and after heating is shown in Table 5. The surface morphology of the coatings after heating is shown in Figure 6.

**Table 5 Surface roughness Ra of coating before and after heating with the pre-coating having a thickness of 5 µm, 10 µm, 15 µm, and 25 µm**

| Thickness of pre-coating (µm) | 5 | 10 | 15 | 19 | 25 |
|---|---|---|---|---|---|
| Ra before heating (µm) | 1.69 | 1.67 | 1.69 | 1.72 | 1.70 |
| Ra after heating (µm) | 1.68 | 1.52 | 1.20 | 1.65 | 2.02 |

It can be seen from the surface roughness of the coating before and after heating that in a case that the thickness of the pre-coating is less than 20 µm, a large surface roughness Ra cannot be guaranteed after heating. In a case that the thickness of the pre-coating is 5 µm, 10 µm, and 15 µm, Ra after heating decreases by 0.01, 0.15, and 0.49 respectively compared with before heating, that is, as the thickness of the coating increases, the downward trend of Ra after heating becomes more significant than before heating. In a case that the thickness of the pre-coating is 19 µm, Ra after heating is equivalent to that before heating. In a case that the thickness of the pre-coating is 25 µm, Ra increases significantly after heating. It can be seen from the surface morphology of the coating after heating that in a case that the thickness of the pre-coating is less than 20 µm, the coating is not fully roughened after heating. In this case, the coating has a small surface roughness. In a case that the pre-coating has a thickness of 5 µm and 10 µm, the coating after heating still has a pit morphology similar to that of the pre-coating. In a case that the pre-coating has a thickness of 15 µm, the coating after heating does not have a pit morphology. In this case, the coating is slightly roughened, that is, in a case that the thickness of the pre-coating is less than or equal to 15 µm, the coating after heating mainly manifests as filling pits. As the thickness of the coating increases, the downward trend of Ra after heating becomes more obvious than before heating. In a case that the thickness of the pre-coating is 19 µm, the roughening degree of the coating after heating further increases, which manifests in that the roughness of the coating after heating begins to increase. In a case that the thickness of the pre-coating is 25 µm, the coating is fully roughened, in which case the coating has a large surface roughness.

Combining the changes in surface roughness and surface morphology of the coating before and after heating, the inventor found that the change in surface roughness of the coating after heating the aluminum or aluminum alloy coating mainly occurs during the processes of liquefaction and solidification of the coating. The surface roughening of the coating after heating is mainly divided into two processes: one is that the liquefied coating fills pits (small spacing, "valleys"), and the other is the roughening of the liquefied coating. In a case that the thickness of the pre-coating is large, such as not less than 20 µm, the amount of liquefaction of the coating after heating is large. In this case, the liquefied coating continues to roughen after filling pits, and the surface roughness Ra is large. In a case that the thickness of the pre-coating is small, the amount of liquefaction of the coating after heating is small. In this case, the liquefied coating mainly fills pits, and a large surface roughness Ra after heating cannot be guaranteed. In this case, the surface roughness Ra of the coating after heating can be increased by increasing the surface roughness Ra of the pre-coating.

Next, the above-mentioned heated steel plate is coated by an appropriate process selected (phosphating, electrophoresis), and the coated coating is subjected to a scratch corrosion test to evaluate the paint adhesion and corrosion resistance (in a case that the maximum corrosion expansion width is not larger than 4 mm, it meets the requirements).

The samples after hot-forming are phosphated with the phosphating agents and test parameters shown in Table 6. Then the obtained phosphated plate is subjected to electrophoresis (electrophoretic paint model: Kansai HT-8000C). The thickness of the dry film of the electrophoresis is about 18 µm. A cyclic corrosion method is then performed, wherein a single cycle includes 8 hours of normal temperature maintenance (25±3°C, during which the salt solution is sprayed 4 times for 3 minutes each time, the composition of the salt solution is: 0.9wt% NaCl, 0. 1wt% CaCl₂, 0.0750.9wt% NaHCO₃), then 8 hours of humid heating (49±2°C, 100%RH), and finally 8 h of drying (60±2°C, <30%RH), for a total of 26 cycles to evaluate the corrosion resistance.

**Table 6 Parameters of phosphating process**

| Step | Process | Model of phosphating agent | Concentration(pt) | Time/S | Temperature/°C |
|---|---|---|---|---|---|
| 1 | Degreasing (dipping) | FC-L5000A | FAL 9-15 | 120 | 50 |
| | | FC-E2021SBB | | | |
| 2 | Deionized water washing | | | 60 | RT |
| 3 | Surface adjusting | PL-X | 2 g/L | 30 | RT |
| 4 | Phosphating | PB-L3035SM | | 120 | 35 |
| | | AD-4813 | FA 0.9 | | |
| | | AD-4856 | TA20.0 | | |
| | | NT-4055 | AC 3.0 | | |
| | | AC-131 | | | |
| 5 | Deionized water washing | | | 60 | RT |

Table 7 shows the key production processes, the surface roughness of the pre-coating, the surface roughness of the coating after heating, and the results of scratch corrosion test corresponding to the examples

**Table 7: Key production processes, surface roughness of pre-coating, surface roughness of coating after heating, and results of scratch corrosion test corresponding to the examples**

| Example | Thickness of base plate (mm) | Thickness of pre-coating (µm) | Tempera ture of annealin g (°C) | Temperat ure of plating solution (°C) | Key process parameters of skin passing | | Ra of pre-coating (µm) | Ra of coating after heating (µm) | Results of scratch corrosion test | |
|---|---|---|---|---|---|---|---|---|---|---|
| | | | | | Ra of Roll (µm) | Rolling force (kN) | | | Maximum corrosion expansion width (mm) | Deter minati on |
| Example 1 | 0.8 | 5 | 730 | 650 | 4.50 | 8206 | 1.85 | 1.83 | 3.2 | Meet require ment |
| Example 2 (compariso n) | 0.8 | 5 | 752 | 655 | 3.50 | 3305 | 1.32 | 1.28 | 5.0 | Not meet require ment |
| Example 3 | 0.8 | 10 | 753 | 650 | 4.00 | 6760 | 2.00 | 1.85 | 3.2 | Meet require ment |
| Example 4 (compariso n) | 0.8 | 10 | 750 | 651 | 3.00 | 4150 | 1.20 | 0.92 | 5.5 | Not meet requirement |
| Example 5 | 0.8 | 15 | 760 | 640 | 4.50 | 8080 | 2.50 | 1.90 | 3.2 | Meet require ment |
| Example 6 (compariso n) | 0.8 | 15 | 755 | 655 | 3.00 | 4688 | 1.59 | 1.30 | 5.0 | Not meet require ment |
| Example 7 | 0.8 | 19 | 750 | 650 | 4.50 | 6800 | 2.80 | 1.85 | 3.2 | Meet require ment |
| Example 8 (compariso n) | 0.8 | 19 | 750 | 655 | 3.00 | 5688 | 1.79 | 1.20 | 5.0 | Not meet require ment |
| Example 9 (compariso n) | 0.8 | 25 | 770 | 650 | 3.00 | 5400 | 2.00 | 2.23 | 2.9 | Meet require ment |
| Example 10 | 1.4 | 5 | 739 | 650 | 4.50 | 7800 | 1.87 | 1.85 | 3.2 | Meet require ment |
| Example 11 (compariso n) | 1.4 | 5 | 760 | 655 | 3.50 | 5500 | 1.42 | 1.38 | 4.9 | Not meet require ment |
| Example 12 | 1.4 | 10 | 790 | 650 | 4.00 | 8080 | 2.20 | 2.00 | 3.0 | Meet require ment |
| Example 13 (compariso n) | 1.4 | 10 | 750 | 652 | 3.50 | 7150 | 1.90 | 1.70 | 4.3 | Not meet require ment |
| Example 14 | 1.4 | 15 | 760 | 640 | 4.50 | 6660 | 2.40 | 1.85 | 3.2 | Meet require ment |
| Example 15 (compariso n) | 1.4 | 15 | 755 | 655 | 4.00 | 5000 | 2.30 | 1.65 | 4.6 | Not meet require ment |
| Example 16 | 1.4 | 19 | 780 | 650 | 4.50 | 7600 | 2.90 | 2.05 | 3.0 | Meet require ment |
| Example 17 (compariso n) | 1.4 | 19 | 750 | 655 | 4.00 | 5600 | 2.40 | 1.58 | 4.4 | Not meet require ment |
| Example 18 (compariso n) | 1.4 | 25 | 770 | 650 | 3.00 | 2180 | 1.70 | 2.02 | 2.9 | Meet require ment |
| Example 19 | 2.0 | 5 | 790 | 650 | 4.50 | 7850 | 1.90 | 1.86 | 3.2 | Meet require ment |
| Example 20 (compariso n) | 2.0 | 5 | 820 | 665 | 4.00 | 5500 | 1.69 | 1.68 | 4.9 | Not meet require ment |
| Example 21 | 2.0 | 10 | 850 | 650 | 4.00 | 7890 | 2.10 | 2.00 | 3.0 | Meet require ment |
| Example 22 (compariso n) | 2.0 | 10 | 750 | 652 | 3.00 | 4700 | 1.67 | 1.52 | 4.6 | Not meet require ment |
| Example 23 | 2.0 | 15 | 760 | 680 | 5.00 | 6000 | 2.70 | 2.15 | 2.8 | Meet require ment |
| Example 24 (compariso n) | 2.0 | 15 | 755 | 655 | 3.00 | 5500 | 1.69 | 1.20 | 5.0 | Not meet require ment |
| Example 25 | 2.0 | 19 | 780 | 650 | 5.50 | 7800 | 3.50 | 2.80 | 3.0 | Meet require ment |
| Example 26 (compariso n) | 2.0 | 19 | 750 | 655 | 3.00 | 3500 | 1.72 | 1.65 | 4.2 | Not meet require ment |
| Example 27 (compariso n) | 2.0 | 25 | 750 | 650 | 5.50 | 6500 | 3.50 | 1.60 | 4.5 | Not meet require ment |

In the above examples, the thicknesses of the pre-coating of 5 µm, 10 µm, 15 µm, and 19 µm are the thickness range of the pre-coating of the present invention. The pre-coating prepared by the method of the present invention is in contrast to the pre-coating prepared without the method of the present invention.

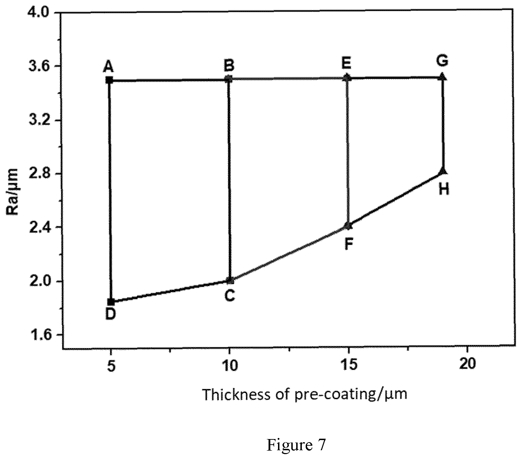

Specifically, with reference to Figure 7, the thickness of the pre-coating is 5 µm. The pre-coatings prepared by the method of the present invention include Examples 1, 10, and 19, and comparative examples include Examples 2, 11, and 20. It can be seen that in a case that the thickness of the pre-coating is 5 µm (greater than or equal to 5 µm and less than or equal to 10 µm), by using Examples 1, 10, and 19 of the present invention, the surface roughness Ra of the pre-coating is ≥ 1.85. The thickness and surface roughness of the pre-coating are limited within the pattern ABCD. The surface roughness Ra of the coating after heating is ≥ 1.80. In this case, the paint has good adhesion and corrosion resistance, which meets the standard requirements. In comparative examples, the surface roughness Ra of the pre-coating is less than 1.85, the thickness and the surface roughness of the pre-coating are not within the pattern ABCD, and the surface roughness Ra of the coating after heating is <1.80. In this case, the paint has poor adhesion and corrosion resistance, which cannot meet the standard requirements.

In a case that the thickness of the pre-coating is 10 µm, the pre-coatings prepared by the method of the present invention include Examples 3, 12, and 21, and comparative examples include Examples 4, 13, and 22. It can be seen that in a case that the thickness of the pre-coating is 10 µm (greater than or equal to 5 µm and less than or equal to 10 µm), by using Examples 3, 12, and 21 of the present invention, the surface roughness Ra of the pre-coating is ≥ 2.00. The thickness and surface roughness of the pre-coating are limited within the pattern ABCD. The surface roughness Ra of the coating after heating is ≥ 1.80. In this case, the paint has good adhesion and corrosion resistance, which meets the standard requirements. In comparative examples, the surface roughness Ra of the pre-coating is <2.00, the thickness and the surface roughness of the pre-coating are not within the pattern ABCD, and the surface roughness Ra of the coating after heating is <1.80. In this case, the paint has poor adhesion and corrosion resistance, which cannot meet the standard requirements.

In a case that the thickness of the pre-coating is 15 µm, the pre-coatings prepared by the method of the present invention include Examples 5, 14, and 23, and comparative examples include Examples 6, 15, and 24. It can be seen that in a case that the thickness of the pre-coating is 15 µm (greater than 10 µm and less than or equal to 15 µm), by using Examples 5, 14, and 23 of the present invention, the surface roughness Ra of the pre-coating is ≥ 2.40. The thickness and the surface roughness of the pre-coating are limited within the pattern BEFC. The surface roughness Ra of the coating after heating is ≥ 1.80. In this case, the paint has good adhesion and corrosion resistance, which meets the standard requirements. In comparative examples, the surface roughness Ra of the pre-coating is <2.40, the thickness and the surface roughness of the pre-coating are not within the pattern BEFC, and the surface roughness Ra of the coating after heating is <1.80. In this case, the paint has poor adhesion and corrosion resistance, which cannot meet the standard requirements.

In a case that the thickness of the pre-coating is 19 µm, the pre-coatings prepared by the method of the present invention include Examples 7, 16, and 25, and comparative examples include Examples 8, 17, and 26. It can be seen that in a case that the thickness of the pre-coating is 19 µm (greater than 15 µm and less than 20 µm), by using Examples 7, 16, and 25 of the present invention, the surface roughness Ra of the pre-coating is ≥ 2.80. The thickness and the surface roughness of the pre-coating are limited within the pattern EGHF. The surface roughness Ra of the coating after heating is ≥ 1.80. In this case, the paint has good adhesion and corrosion resistance, which meets the standard requirements. In comparative examples, the surface roughness Ra of the pre-coating is <2.80, the thickness and the surface roughness of the pre-coating are not within the pattern EGHF, and the surface roughness Ra of the coating after heating is <1.80. In this case, the paint has poor adhesion and corrosion resistance, which cannot meet the standard requirements.

In addition, the pre-coating having a thickness of 25 µm commonly used by Arcelor Mittal is selected as a comparison, in particular, Examples 9, 18, and 27. It can be seen that in a case that the surface roughness of the pre-coating is not greater than 2.00 (Examples 9 and 18), the surface roughness Ra of the coating after heating is ≥ 1.80. In this case, the paint has good adhesion and corrosion resistance, and the maximum corrosion expansion width is 2.9 mm, which meets the standard requirements. However, in a case that the surface roughness of the pre-coating is too large (Example 27, Ra is 3.50), the surface roughness Ra of the coating after heating is <1.80. In this case, the paint has poor adhesion and corrosion resistance, which cannot meet the standard requirements, indicating that even if the thickness of the pre-coating is large, in a case that the surface roughness of the pre-coating is large enough, high surface roughness cannot be guaranteed after heating.

Generally, the pre-coatings of the present invention prepared by the method of the present invention in a thickness range of 5 µm, 10 µm, 15 µm, and 19 µm, in particular, Examples 1, 3, 5, 7, 10, 12, 14, 16, 19, 21, 23, and 25, have the maximum corrosion expansion width of the paint of 2.8 mm to 3.2 mm. However, the pre-coatings prepared without using the present invention, in particular, Examples 2, 4, 6, 8, 11, 13, 15, 17, 20, 22, 24, and 26, have the maximum corrosion expansion width of the paint of greater than 4.0 mm, which cannot meet the requirements. The maximum corrosion expansion width of the pre-coating with a thickness of 25 µm is 2.9 mm (Examples 9 and 18), that is, the paint adhesion and corrosion resistance of the pre-coating prepared by the present invention are equivalent to that of the pre-coating with a thickness commonly used by Arcelor Mittal. However, the pre-coating prepared without using the present invention has poor paint adhesion and corrosion resistance.

In a case that the thickness of the pre-coating is small, how to ensure a high surface roughness of the coating after hot forming is particularly important to improve the paint adhesion and corrosion resistance of the aluminum alloy coating after hot forming.

According to the above examples, for pre-coating the aluminum or aluminum alloy coating, in a case that the thickness of the pre-coating is small (less than 20 µm), after hot forming of the pre-coating prepared by the present invention, the coating has a high roughness, which can ensure good paint adhesion and corrosion resistance.

The above embodiments have elaborated the purpose and implementation effects of the present invention. It should be understood that the above embodiments are only descriptions of preferred embodiments of the present invention, and do not limit the concept and scope of the present invention. Within the spirit and principles of the present invention, and without departing from the design ideas of the present invention, various modifications, equivalent replacements, improvements, and the like made by those skilled in the art or by adopting the technical concepts and technical solutions of the present invention are within the protection scope of the present invention.

## Claims

1. A pre-coated steel plate for hot forming, wherein a pre-coating is provided on at least one surface of a base steel, and the pre-coating has a thickness of 5 µm to 19 µm, wherein in a case that the pre-coating has a thickness of greater than or equal to 5 µm and less than or equal to 10 µm, the thickness of the pre-coating and the surface roughness of the pre-coating are limited within pattern ABCD, which comprises coordinates of the thickness of the pre-coating and the surface roughness of the pre-coating defined by A (5 µm, 3.5 µm), B (10 µm, 3.5 µm), C (10 µm, 2.0 µm), and D (5 µm, 1.85 µm); in a case that the thickness of the pre-coating is greater than 10 µm and less than or equal to 15 µm, the thickness of the pre-coating and surface roughness of the pre-coating are defined within pattern BEFC, which comprises coordinates of the thickness of the pre-coating and the surface roughness of the pre-coating defined by B (10 µm, 3.5 µm), E (15 µm, 3.5 µm), F (15 µm, 2.4 µm), and C (10 µm, 2.0 µm); in a case that the thickness of the pre-coating is greater than 15 µm and less than or equal to 19 µm, the thickness of the pre-coating and surface roughness of the pre-coating are defined within pattern EGHF, which comprises coordinates of the thickness of the pre-coating and the surface roughness of the pre-coating defined by E (15 µm, 3.5 µm), G (19 µm, 3.5 µm), H (19 µm, 2.8 µm), and F (15 µm, 2.4 µm).

2. A method for preparing the pre-coated steel plate according to claim 1, comprising steelmaking→continuous casting→hot rolling→pickling and cold rolling→coating process, wherein the coating process comprises a skin passing process, and in the skin passing process, a surface roughness Ra of a roll is 3.0 µm to 6.0 µm, and a rolling force is 4000 kN to 9000 kN.

3. The method according to claim 2, wherein in the coating process, a coating liquid comprises, in mass percentage, 8-11% of Si, 2-4% of Fe, and balance of aluminum or aluminum alloy and inevitable impurities.

4. The method according to claim 2, wherein the coating process comprises a continuous annealing process, which has parameters as follows: the annealing is conducted at a temperature controlled at 720°C to 850°C, and kept at this temperature for 60 s to 120 s under a reducing atmosphere comprising 5-10% H₂+ N₂ by volume percentage (that is, in terms of volume percentage of the reducing atmosphere, H₂ accounts for 5-10%, and the rest is N₂), the oxygen content is controlled below 20 ppm, and the dew point is controlled at -60°C to 0°C.

5. A coated hot-formed steel member, which is prepared from the pre-coated steel plate according to claim 1 through a hot forming process, wherein the surface roughness of the steel member meets Ra ≥ 1.80 µm.

6. The coated hot-formed steel member according to claim 5, wherein the coating consists of only a first layer from the base steel to the surface, and the first layer is an interdiffusion layer containing Al and Si, which comprises greater than or equal to 80% of Fe by weight, less than or equal to 5% of Si by weight, and balance of Al.

7. The coated hot-formed steel member according to claim 5, wherein the coating consists of, from the base steel to the surface, a first layer and a second layer sequentially:
the first layer is an interdiffusion layer containing Al and Si, which comprises greater than or equal to 80% of Fe by weight, less than or equal to 5% of Si by weight, and balance of Al,
the second layer is a first intermetallic compound layer containing Al and Si, which comprises 55% to 79% of Fe by weight, greater than or equal to 2% of Si by weight, and balance of Al.

8. The coated hot-formed steel member according to claim 5, wherein the coating consists of, from the base steel to the surface, a first layer, a second layer and a discontinuous surface layer sequentially:
the first layer is an interdiffusion layer containing Al and Si, which comprises greater than or equal to 80% of Fe by weight, less than or equal to 5% of Si by weight, and balance of Al,
the second layer is a first intermetallic compound layer containing Al and Si, which comprises 55% to 79% of Fe by weight, greater than or equal to 2% of Si by weight, and balance of Al,
the surface layer is discontinuous, and comprises a first intermetallic compound containing Al and Si and a second intermetallic compound containing Al and Si, wherein the first intermetallic compound layer comprises 55% to 79% of Fe by weight, greater than or equal to 2% of Si by weight, and balance of Al, and the second intermetallic compound comprises 30% to 50% of Fe by weight, less than or equal to 2% of Si by weight, and balance of Al.

9. The coated hot-formed steel member according to claim 5, wherein the coating consists of, from the base steel to the surface, a first layer, a second layer and a third layer sequentially:
the first layer is an interdiffusion layer containing Al and Si, which comprises greater than or equal to 80% of Fe by weight, less than or equal to 5% of Si by weight, and balance of Al,
the second layer is a second intermetallic compound layer containing Al and Si, which comprises 30% to 50% of Fe by weight, less than or equal to 2% of Si by weight, and balance of Al,
the third layer is a first intermetallic compound layer containing Al and Si, which comprises 55% to 79% of Fe by weight, greater than or equal to 2% of Si by weight, and balance of Al.

10. The coated hot-formed steel member according to claim 5, wherein the coating consists of, from the base steel to the surface, a first layer, a second layer, a third layer and a discontinuous surface layer sequentially:
the first layer is an interdiffusion layer containing Al and Si, which comprises greater than or equal to 80% of Fe by weight, less than or equal to 5% of Si by weight, and balance of Al,
the second layer is a second intermetallic compound layer containing Al and Si, which comprises 30% to 50% of Fe by weight, less than or equal to 2% of Si by weight, and balance of Al,
the third layer is a first intermetallic compound layer containing Al and Si, which comprises 55% to 79% of Fe by weight, greater than or equal to 2% of Si by weight, and balance of Al,
the surface layer is discontinuous, and comprises a first intermetallic compound containing Al and Si and a second intermetallic compound containing Al and Si, wherein the first intermetallic compound layer comprises 55% to 79% of Fe by weight, greater than or equal to 2% of Si by weight, and balance of Al, and the second intermetallic compound comprises 30% to 50% of Fe by weight, less than or equal to 2% of Si by weight, and balance of Al.

11. The coated hot-formed steel member according to claim 5, wherein the coating consists of, from the base steel to the surface, a first layer, a second layer, a third layer and a fourth layer sequentially:
the first layer is an interdiffusion layer containing Al and Si, which comprises greater than or equal to 80% of Fe by weight, less than or equal to 5% of Si by weight, and balance of Al,
the second layer is a second intermetallic compound layer containing Al and Si, which comprises 30% to 50% of Fe by weight, less than or equal to 2% of Si by weight, and balance of Al,
the third layer is a first intermetallic compound layer containing Al and Si, which comprises 55% to 79% of Fe by weight, greater than or equal to 2% of Si by weight, and balance of Al,
the fourth layer is a second intermetallic compound layer containing Al and Si, which comprises 30% to 50% of Fe by weight, less than or equal to 2% of Si by weight, and balance of Al.

12. The coated hot-formed steel member according to claim 5, wherein a total thickness of the coated hot-formed steel member is 0.4 mm to 3.0 mm.

13. A land motor vehicle, comprising the coated hot-formed steel member according to any one of claims 5 to 12.
